(19) 
**Europäisches Patentamt**
**European Patent Office**
**Office européen des brevets**

(11) **EP 3 073 536 A1**

(12) **EUROPEAN PATENT APPLICATION**

(43) Date of publication:
**28.09.2016 Bulletin 2016/39**

(51) Int Cl.:
***H01L 31/048*** (2006.01)

(21) Application number: **16161535.6**

(22) Date of filing: **22.03.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **25.03.2015 JP 2015062510**

(71) Applicant: **KABUSHIKI KAISHA TOYOTA
JIDOSHOKKI
Kariya-shi, Aichi-ken, 448-8671 (JP)**

(72) Inventors:
• **INABA, Hirotaka**
**Kariya-shi,, Aichi 448-8671 (JP)**
• **OKUMURA, Kazumasa**
**Kariya-shi,, Aichi 448-8671 (JP)**
• **KIMURA, Kazutaka**
**Toyota-shi,, Aichi 471-8571 (JP)**

(74) Representative: **TBK
Bavariaring 4-6
80336 München (DE)**

(54) **SOLAR BATTERY MODULE**

(57)    A solar battery module includes: a first cover (111) formed in a plate shape; a second cover (112) formed in a plate shape and arranged so as to face the first cover (111); a solar battery cell (113) arranged between the first cover (111) and the second cover (112); and a sealing material portion (114) joining the first cover (111) and the second cover (112) while filling a space therebetween to seal the solar battery cell (113). In a joint surface with the sealing material portion (114), at least one of the first cover (111) and the second cover (112) has a gradually changing portion (111d, 112d) that is gradually decreased in thickness such that the sealing material portion (114) is gradually increased in thickness as being farther away from a center portion of the solar battery cell (113). At least a part of the gradually changing portion (111d, 112d) overlaps with the solar battery cell (113), as seen in a thickness direction of the solar battery cell (113).

FIG.3

EP 3 073 536 A1

**Description**

This nonprovisional application is based on Japanese Patent Application No. 2015-062510 filed on March 25, 2015, with the Japan Patent Office, the entire contents of which are hereby incorporated by reference.

BACKGROUND OF THE INVENTION

Field of the Invention

The present invention relates to a solar battery module.

Description of the Background Art

There exists Japanese Patent Laying-Open No. 2005-191479 as a prior art document disclosing the configuration of a solar battery module. In the solar battery module disclosed in Japanese Patent Laying-Open No. 2005-191479, a back contact-type solar battery cell having both electrodes of a P-type electrode and an N-type electrode provided on its back surface is sealed in a sealing material. A glass plate as a protection member is attached to the front surface side while a resin film as a protection member is attached to the back surface side, thereby forming a stacked body.

According to the solar battery module disclosed in Japanese Patent Laying-Open No. 2005-191479, the shape of the interconnector is optimized, thereby suppressing disconnection of the interconnector that undergoes fatigue due to thermal expansion and shrinkage of the solar battery module. In the solar battery module disclosed in Japanese Patent Laying-Open No. 2005-191479, however, the sealing material may peel off from the surface protection member due to thermal expansion and shrinkage of the solar battery module.

SUMMARY OF THE INVENTION

An object of the present invention is to provide a solar battery module by which a sealing material can be suppressed from peeling off from a cover as a surface protection member due to thermal expansion and shrinkage of the solar battery module.

A solar battery module according to the present invention includes: a first cover formed in a plate shape; a second cover formed in a plate shape and arranged so as to face the first cover; a solar battery cell arranged between the first cover and the second cover; and a sealing material portion joining the first cover and the second cover while filling a space therebetween to seal the solar battery cell. In a joint surface with the sealing material portion, at least one of the first cover and the second cover includes a gradually changing portion that is gradually decreased in thickness such that the sealing material portion is gradually increased in thickness as being farther away from a center portion of the solar battery cell. At least a part of the gradually changing portion overlaps with the solar battery cell as seen in a thickness direction of the solar battery cell.

According to the present invention, a sealing material can be suppressed from peeling off from a cover due to thermal expansion and shrinkage of the solar battery module.

The foregoing and other objects, features, aspects and advantages of the present invention will become more apparent from the following detailed description of the present invention when taken in conjunction with the accompanying drawings.

BRIEF DESCRIPTION OF THE DRAWINGS

Fig. 1 is a perspective view showing an external appearance of a vehicle equipped with a solar battery module according to the first embodiment of the present invention.
Fig. 2 is a plan view showing an external appearance of the solar battery module according to the first embodiment of the present invention, as seen from a direction indicated by an arrow II in Fig. 1.
Fig. 3 is a cross-sectional view showing the configuration of the solar battery module according to the first embodiment of the present invention, as seen from the direction indicated by an arrow line III-III in Fig. 2.
Fig. 4 is a cross-sectional view showing the state where a solar battery module according to a comparative example thermally expands.
Fig. 5 is a cross-sectional view showing the state where the solar battery module according to the comparative example thermally shrinks.
Fig. 6 is a diagram obtained by adding, to Fig. 3, two direct lines located along the inclined surfaces forming gradually changing portions of the first and second covers, respectively.
Fig. 7 is a cross-sectional view showing the state where the solar battery module according to the first embodiment of the present invention thermally expands.
Fig. 8 is a cross-sectional view showing the configuration of a solar battery module according to the second embodiment of the present invention.
Fig. 9 is a cross-sectional view showing the configuration of a solar battery module according to the third embodiment of the present invention.
Fig. 10 is a cross-sectional view showing the configuration of a solar battery module according to the fourth embodiment of the present invention.
Fig. 11 is a cross-sectional view showing the configuration of a solar battery module according to the fifth embodiment of the present invention.

DESCRIPTION OF THE PREFERRED EMBODIMENTS

A solar battery module according to each embodiment of the present invention will be hereinafter described with reference to the accompanying drawings. In the following description, the same or corresponding components in the figures are designated by the same reference characters, and description thereof will not be repeated.

(First Embodiment)

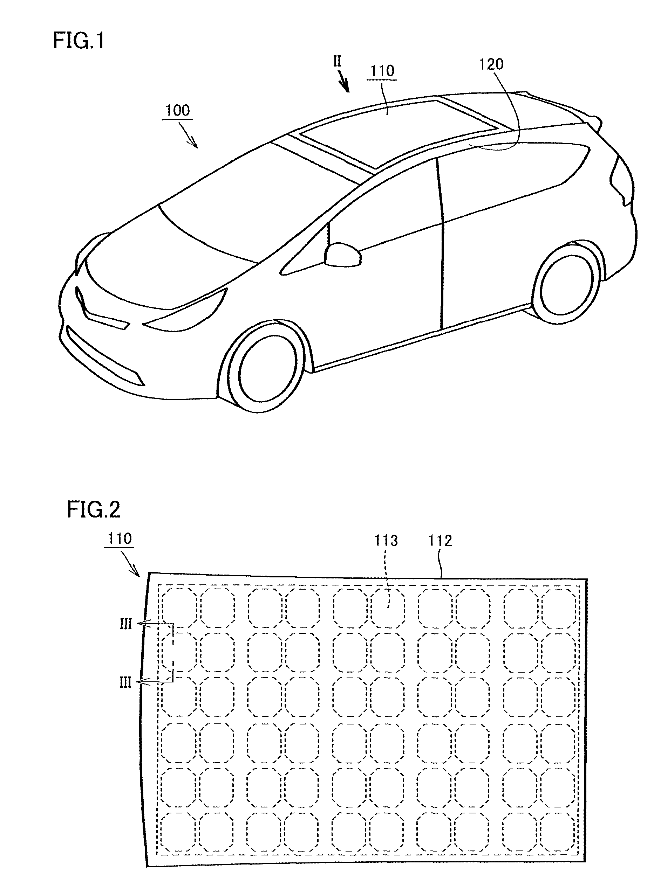

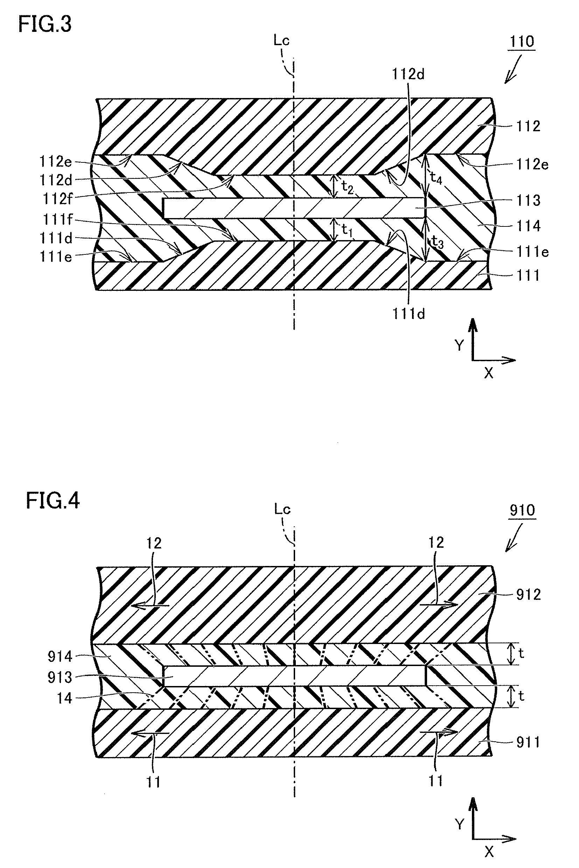

Fig. 1 is a perspective view showing an external appearance of a vehicle equipped with a solar battery module according to the first embodiment of the present invention. Fig. 2 is a plan view showing an external appearance of a solar battery module according to the first embodiment of the present invention, as seen from the direction indicated by an arrow II in Fig. 1. Fig. 3 is a cross-sectional view showing the configuration of the solar battery module according to the first embodiment of the present invention, as seen from the direction indicated by an arrow line III-III in Fig. 2.

In Fig. 3, the width direction and the thickness direction of the solar battery cell are indicated by X and Y, respectively. Fig. 3 also shows a center line Lc passing through the center of the solar battery cell in the width direction and extending in the thickness direction of the solar battery cell.

As shown in Figs. 1 to 3, a vehicle 100 equipped with a solar battery module 110 according to the first embodiment of the present invention is an automobile. The vehicle 100 includes a solar battery module 110 forming a roof, and a roof side member 120 that constitutes a part of a vehicle body. The vehicle is not limited to an automobile, but may be an electric train, for example. In the present embodiment, the solar battery module 110 is formed in an approximately plate shape, but may be formed in a curved shape.

The solar battery module 110 includes: a first cover 111 formed in a plate shape; a second cover 112 formed in a plate shape and arranged so as to face the first cover 111; a solar battery cell 113 arranged between the first cover 111 and the second cover 112; and a sealing material portion 114 joining the first cover 111 and the second cover 112 while filling a space therebetween to thereby seal the solar battery cell 113.

The first cover 111 has an approximately rectangular outer shape as seen in plan view. The first cover 111 is formed in a plate shape in the present embodiment, but may be formed in a curved shape. In the present embodiment, the first cover 111 is a plate made of polycarbonate, but is not limited thereto and may be a plate made of other resins such as acrylic, a plate made of CFRP (carbon-fiber-reinforced plastic) or a plate made of metal such as aluminum, or may be a sheet made of resin such as polyethylene terephthalate.

The first cover 111 is formed by injection-molding polycarbonate. It is to be noted that the molding method of the first cover 111 is not limited to injection molding, but may be vacuum molding and the like.

In a joint surface with the sealing material portion 114, the first cover 111 has a gradually changing portion 111d that is gradually decreased in thickness such that the sealing material portion 114 is gradually increased in thickness as being farther away from the center portion of the solar battery cell 113.

In the present embodiment, the gradually changing portion 111d is formed of an inclined surface that is inclined so as to be farther away from the solar battery cell 113 as being farther away from the center line Lc. The gradually changing portion 111d is arranged in an annular shape, as seen in the thickness direction of the solar battery cell 113.

The gradually changing portion 111d overlaps with the solar battery cell 113, as seen in the thickness direction of the solar battery cell 113. In the present embodiment, the gradually changing portion 111d overlaps with the end portion of the solar battery cell 113, as seen in the thickness direction of the solar battery cell 113. The terminal end of the gradually changing portion 111d that is located farthest away from the center line Lc overlaps with the terminal end of the solar battery cell 113 in its width direction, as seen in the thickness direction of the solar battery cell 113.

In the present embodiment, in a joint surface with the sealing material portion 114, the first cover 111 has a horizontal portion 111f that is located adjacent to the gradually changing portion 111d so as to face the center portion of the solar battery cell 113. The horizontal portion 111f is formed of a horizontal surface and arranged in a rectangular shape as seen in the thickness direction of the solar battery cell 113. In other words, the horizontal portion 111f and the gradually changing portion 111d are arranged so as to form a truncated square pyramid.

In the joint surface with the sealing material portion 114, the first cover 111 has a surrounding portion 111e surrounding the circumference of the gradually changing portion 111d. The surrounding portion 111e is formed of a horizontal surface and arranged in a lattice shape as seen in the thickness direction of the solar battery cell 113.

The second cover 112 has an approximately rectangular outer shape as seen in plan view. The second cover 112 is formed in a plate shape in the present embodiment. However, in the case where the first cover 111 is curved, the second cover 112 is also curved at the curvature that is approximately the same as that of the first cover 111. In the present embodiment, the second cover 112 is a plate made of polycarbonate, but is not limited thereto and may be a plate made of other resins such as acrylic. The second cover 112 has average thickness and rigidity that are equal to or greater than those of the first cover 111.

The second cover 112 is formed by injection-molding transparent polycarbonate. It is to be noted that the molding method of the second cover 112 is not limited to injection molding, but may be vacuum molding and the like.

In the joint surface with the sealing material portion 114, the second cover 112 has a gradually changing portion 112d that is gradually decreased in thickness such that the sealing material portion 114 is gradually increased in thickness as being farther away from the center portion of the solar battery cell 113.

In the present embodiment, the gradually changing portion 112d is formed of an inclined surface that is inclined so as to be farther away from the solar battery cell 113 as being farther away from the center line Lc. The gradually changing portion 112d is arranged in an annular shape, as seen in the thickness direction of the solar battery cell 113.

The gradually changing portion 112d overlaps with the solar battery cell 113, as seen in the thickness direction of the solar battery cell 113. In the present embodiment, the gradually changing portion 112d overlaps with the end portion of the solar battery cell 113, as seen in the thickness direction of the solar battery cell 113. The terminal end of the gradually changing portion 112d that is located farthest away from the center line Lc overlaps with the terminal end of the solar battery cell 113 in its width direction, as seen in the thickness direction of the solar battery cell 113.

In the present embodiment, in the joint surface with the sealing material portion 114, the second cover 112 has a horizontal portion 112f that is located adjacent to the gradually changing portion 112d so as to face the center portion of the solar battery cell 113. The horizontal portion 112f is formed of a horizontal surface and arranged in a rectangular shape as seen in the thickness direction of the solar battery cell 113. In other words, the horizontal portion 112f and the gradually changing portion 112d are arranged so as to form a truncated square pyramid.

In the joint surface with the sealing material portion 114, the second cover 112 has a surrounding portion 112e surrounding the circumference of the gradually changing portion 112d. The surrounding portion 112e is formed of a horizontal surface and arranged in a lattice shape as seen in the thickness direction of the solar battery cell 113.

A plurality of solar battery cells 113 are arranged at a distance from each other in matrix. The plurality of solar battery cells 113 are electrically connected to each other. Specifically, the plurality of solar battery cells 113 are connected in series to each other to form a solar battery string. A plurality of solar battery strings are connected in series or in parallel to each other.

The sealing material portion 114 is located in a region sandwiched between the first cover 111 and the second cover 112. In the present embodiment, the sealing material portion 114 is formed of EVA (Ethylene-Vinyl Acetate). It is to be noted that the material forming the sealing material portion 114 is not limited to EVA, but may be PVB (Poly Vinyl Butyral), silicone resin, ionomer resin, or the like.

The minimum thickness of the sealing material portion 114 between the solar battery cell 113 and the first cover 111 is indicated by $t_1$. The minimum thickness of the sealing material portion 114 between the solar battery cell 113 and the second cover 112 is indicated by $t_2$. As the minimum thicknesses $t_1$ and the minimum thicknesses $t_2$ of the sealing material portion 114, the minimum thickness required to seal the solar battery cell 113 is ensured.

The thickness of the sealing material portion 114 between the first cover 111 and the terminal end of the solar battery cell 113 in the width direction is indicated by $t_3$. The thickness of the sealing material portion 114 between the second cover 112 and the terminal end of the solar battery cell 113 in the width direction is indicated by $t_4$. As the thickness $t_3$ and the thickness $t_4$ of the sealing material portion 114, the minimum thickness is ensured, which is required to prevent the sealing material portion 114 from peeling off from the first cover 111 and the second cover 112 due to a shearing strain $\gamma$ of the sealing material portion 114 described later.

A solar battery module 910 according to a comparative example will be hereinafter described in order to describe structural characteristics of the solar battery module 110 according to the present embodiment.

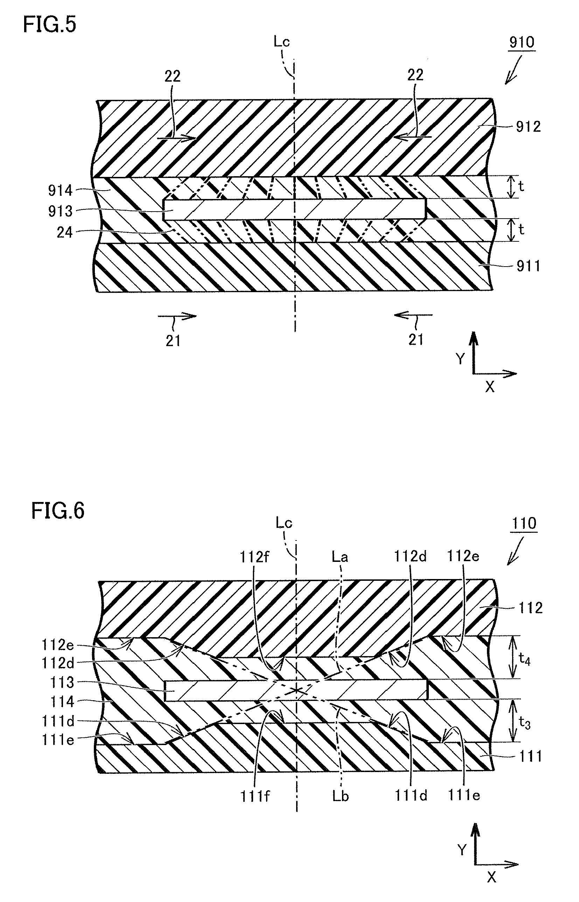

Fig. 4 is a cross-sectional view showing the state where a solar battery module according to a comparative example thermally expands. Fig. 5 is a cross-sectional view showing the state where the solar battery module according to the comparative example thermally shrinks. Figs. 4 and 5 each are a diagram shown in cross section as seen from the same direction as that in Fig. 3.

In each of Figs. 4 and 5, the width direction and the thickness direction of the solar battery cell are indicated by X and Y, respectively. Also, Figs. 4 and 5 each show a center line Lc passing through the center of the solar battery cell in the width direction and extending in the thickness direction of the solar battery cell. Also, Figs. 4 and 5 each schematically show a shearing strain of the sealing material portion caused by thermal expansion and shrinkage of the solar battery module.

As shown in Figs. 4 and 5, the solar battery module 910 according to the comparative example includes: a first cover 911 formed in a plate shape; a second cover 912 formed in a plate shape and arranged so as to face the first cover 911; a solar battery cell 913 arranged between the first cover 911 and the second cover 912; and a sealing material portion 914 joining the first cover 911 and the second cover 912 while filling a space therebetween to seal the solar battery cell 913.

The first cover 911 has an approximately rectangular outer shape as seen in plan view. The first cover 911 has a thickness that is entirely approximately uniform. The first cover 911 has a joint surface with the sealing material portion 914, which is entirely formed of a horizontal surface. The first cover 911 is a plate made of polycarbonate.

The second cover 912 has an approximately rectangular outer shape as seen in plan view. The second cover 912 has a thickness that is entirely approximately uniform. The second cover 912 has a joint surface with the sealing material portion 914, which is entirely formed of a horizontal surface. The second cover 912 is a plate made of polycarbonate.

A plurality of solar battery cells 913 are arranged at a distance from each other in matrix. The plurality of solar battery cells 913 are electrically connected to each other. Specifically, the plurality of solar battery cells 913 are connected in series to each other to thereby form a solar battery string. A plurality of solar battery strings are connected in parallel to each other.

The sealing material portion 914 is located in a region sandwiched between the first cover 911 and the second cover 912. The sealing material portion 914 is formed of EVA (Ethylene-Vinyl Acetate).

The first cover 911 and the second cover 912 are made of polycarbonate having a coefficient of linear expansion of $70 \times 10^{-6}$ (1/K). The solar battery cell 913 is made mainly of silicon that has a coefficient of linear expansion of $4 \times 10^{-6}$ (1/K).

Therefore, as shown in Fig. 4, in the state where the solar battery module 910 according to the comparative example thermally expands, the first cover 911 expands as indicated by an arrow 11 relative to the solar battery cell 913 while the second cover 912 expands as indicated by an arrow 12 relative to the solar battery cell 913. Thermal expansion of the solar battery module 910 produces a shearing strain in the sealing material portion 914 as shown by an imaginary line 14.

As shown in Fig. 5, in the state where the solar battery module 910 according to the comparative example thermally shrinks, the first cover 911 shrinks as indicated by an arrow 21 relative to the solar battery cell 913 while the second cover 912 shrinks as indicated by an arrow 22 relative to the solar battery cell 913. Thermal shrinkage of the solar battery module 910 produces a shearing strain in the sealing material portion 914 as shown by an imaginary line 24.

A positional displacement amount $\Delta x$ of each of the first cover 911 and the second cover 912 relative to the solar battery cell 913 caused by thermal expansion and shrinkage of the solar battery module 910 is calculated by the following equation 1.

$$\Delta x = (\alpha_1 - \alpha_2) \times \Delta T \times x \text{ ... (equation 1)}$$

In the equation 1, $\alpha_1$ represents a coefficient of linear expansion of polycarbonate, $\alpha_2$ represents a coefficient of linear expansion of silicon, $\Delta T$ represents a temperature change amount, and x represents a distance from the center line Lc of the solar battery cell 913 in its width direction.

As apparent from the equation 1, the positional displacement amount $\Delta x$ of each of the first cover 911 and the second cover 912 relative to the solar battery cell 913 is proportional to the distance x from the center of the solar battery cell 913.

The shearing strain $\gamma$ of the sealing material portion 914 satisfies the following equation 2.

$$\gamma = \Delta x/t \text{ ... (equation 2)}$$

In the equation 2, t represents a thickness of the sealing material portion 914 that is located between the solar battery cell 913 and each of the first cover 911 and the second cover 912.

As described above, since the thickness of each of the first cover 911 and the second cover 912 is entirely approximately uniform, the thickness t of the sealing material portion 914 is fixed. The positional displacement amount $\Delta x$ is proportional to the distance x from the center of the solar battery cell 913. Therefore, the shearing strain $\gamma$ of the sealing material portion 914 is proportional to the distance x from the center of the solar battery cell 913.

In the solar battery module 910 according to the comparative example, the sealing material portion 914 is more likely to peel off from each of the first cover 911 and the second cover 912 at the position where it faces the end portion of the solar battery cell 913 in the width direction at which the shearing strain $\gamma$ of the sealing material portion 914 increases.

Therefore, in the solar battery module 110 according to the present embodiment, the first cover 111 has the gradually changing portion 111d in the joint surface with the sealing material portion 114 while the second cover 112 has the gradually changing portion 112d in the joint surface with the sealing material portion 114. In the present embodiment, each of the gradually changing portions 111d and 112d is formed of an inclined surface.

Fig. 6 is a diagram obtained by adding, to Fig. 3, two direct lines located along the inclined surfaces forming the gradually changing portions of the first and second covers, respectively. As shown in Fig. 6, each of two straight lines La and Lb located along the inclined surfaces forming the gradually changing portions 111d and 112d in the first cover 111 and the second cover 112, respectively, is a straight line that passes through the center of the solar battery cell 113 at a constant inclination.

Specifically, the sealing material portion 114 between the solar battery cell 113 and each of the gradually changing portions 111d and 112d is increased in thickness at a constant rate as being farther away from the center of the solar battery cell 113 in the width direction.

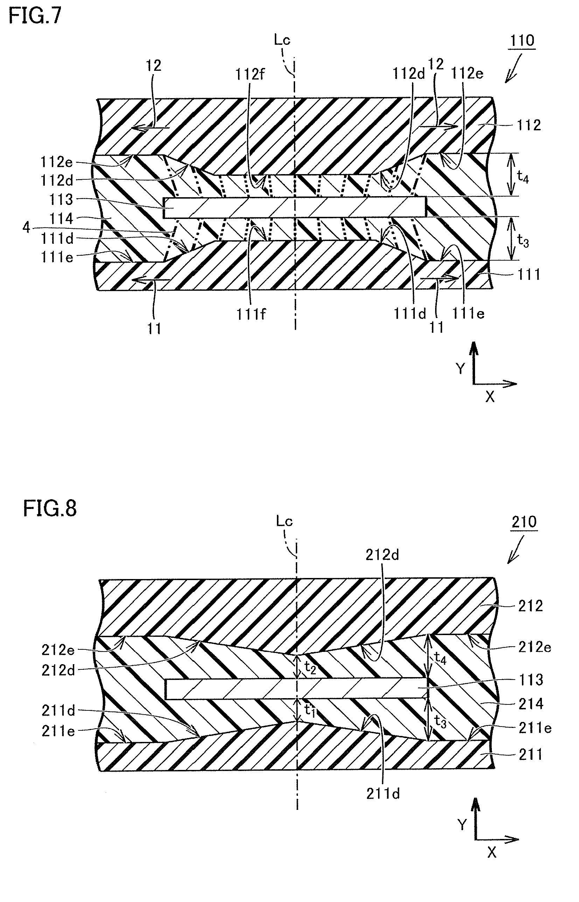

Fig. 7 is a cross-sectional view showing the state where the solar battery module according to the first embodiment of the present invention thermally expands. Fig. 7 is a diagram shown in cross section as seen from the same direction as that in Fig. 3.

As shown in Fig. 7, in the state where the solar battery module 110 according to the present embodiment thermally expands, the first cover 111 expands as indicated by an arrow 11 relative to the solar battery cell 113 while the second cover 112 expands as indicated by an arrow 12 relative to the solar battery cell 113. Thermal expansion of the solar battery module 110 produces a shearing strain in the sealing material portion 114 as shown by an imaginary line 4.

As described above, in the solar battery module 110 according to the present embodiment, the sealing material portion 114 between the solar battery cell 113 and each of the gradually changing portions 111d and 112d is increased in thickness at a constant rate as being farther away from the center of the solar battery cell 113 in the width direction. In other words, in the above-mentioned equation 2, the thickness t of the sealing material portion 114 is proportional to the distance x from the center of the solar battery cell 113. Furthermore, as can be seen from the equation 1, the positional displacement amount $\Delta x$ of each of the gradually changing portions 111d and 112d relative to the solar battery cell 113 is proportional to the distance x from the center of the solar battery cell 113. Therefore, according to the equation 2, the shearing strain $\gamma$ of the sealing material portion 114 between the solar battery cell 113 and each of the gradually changing portions 111d and 112d exhibits a constant value.

Each of the gradually changing portions 111d and 112d overlaps with the end portion of the solar battery cell 113 as seen in the thickness direction of the solar battery cell 113. Accordingly, the shearing strain $\gamma$ of the sealing material portion 114 between the solar battery cell 113 and each of the gradually changing portions 111d and 112d is set at a constant value, so that the sealing material portion 114 can be suppressed from peeling off from each of the first cover 111 and the second cover 112 at the position where it faces the end portion of the solar battery cell 113 in the width direction.

In the solar battery module 110 according to the present embodiment, the horizontal portions 111f and 112f are provided in the first cover 111 and the second cover 112, respectively, so as to be located to face the center portion of the solar battery cell 113, in which case the thicknesses $t_1$ and $t_2$ of the sealing material portion 114 between the solar battery cell 113 and the horizontal portions 111f and 112f, respectively, are the smallest. Thereby, the jointing force between the solar battery cell 113 and each of the horizontal portions 111f and 112f is ensured, so that the positional displacement of the solar battery cell 113 in its width direction can be stably suppressed.

In the solar battery module 110 according to the present embodiment, as compared with the case where the sealing material portion 114 is formed to have a thickness that is entirely and constantly increased for suppressing the sealing material portion 114 from peeling off, the solar battery module 110 can be kept thin while the materials constituting the sealing material portion 114 can be suppressed from increasing.

Furthermore, by forming the first cover 111 by injection molding or vacuum molding, the gradually changing portion 111d, the horizontal portion 111f and the surrounding portion 111e can be readily provided in the first cover 111. Also, by forming the second cover 112 by injection molding or vacuum molding, the gradually changing portion 112d, the horizontal portion 112f and the surrounding portion 112e can be readily provided in the second cover 112.

In the solar battery module 110 according to the present embodiment, the first cover 111 and the second cover 112 have the gradually changing portions 111d and 112d, respectively, but the present invention is not limited thereto, and one of the first cover 111 and the second cover 112 may have the gradually changing portions 111d and 112d. Furthermore, the gradually changing portion 111d of the first cover 111 and the gradually changing portion 112d of the second cover 112 may be different in gradually-changing degree from each other.

For example, only the second cover 112 that is higher in thickness and rigidity than the first cover 111 may have the gradually changing portion 112d. In the case where the second cover 112 is higher in thickness and rigidity than the first cover 111, the second cover 112 is higher in thermal expansion and shrinkage degree than the first cover 111. In this case, the shearing strain of the sealing material portion 114 between the second cover 112 and the solar battery cell 113 tends to be larger than the shearing strain of the sealing material portion 114 between the first cover 111 and the solar battery cell 113. Accordingly, the gradually changing portion 112d is provided only in the second cover 112 where the sealing material portion 114 is more likely to peel off, so that the sealing material portion 114 can be efficiently suppressed from peeling off.

A solar battery module according to the second embodiment of the present invention will be hereinafter described. Since a solar battery module 210 according to the present embodiment is different from the solar battery module 110 according to the first embodiment only in that a horizontal portion is not provided in each of the first cover and the second cover, the description of other configurations will not be repeated.

(Second Embodiment)

Fig. 8 is a cross-sectional view showing the configuration of a solar battery module according to the second embodiment of the present invention. Fig. 8 is a diagram shown in cross section as seen from the same direction as that in Fig. 3. In Fig. 8, the width direction and the thickness direction of the solar battery cell are indicated by X and Y, respectively. Fig. 8 also shows a center line Lc passing through the center of the solar battery cell in the width direction and extending in the thickness direction of the solar battery cell.

As shown in Fig. 8, the solar battery module 210 according to the second embodiment of the present invention includes: a first cover 211 formed in a plate shape; a second cover 212 formed in a plate shape and arranged so as to face the first cover 211; a solar battery cell 113 arranged between the first cover 211 and the second cover 212; and a sealing material portion 214 joining the first cover 211 and the second cover 212 while filling a space therebetween to seal the solar battery cell 113.

In the joint surface with the sealing material portion 214, the first cover 211 has a gradually changing portion 211d that is gradually decreased in thickness such that the sealing material portion 214 is gradually increased in thickness as being farther away from the center portion of the solar battery cell 113.

In the present embodiment, the gradually changing portion 211d is formed of an inclined surface that is inclined so as to be farther away from the solar battery cell 113 as being farther away from the center line Lc. The gradually changing portion 211d is arranged in a rectangular shape, as seen in the thickness direction of the solar battery cell 113. In other words, the gradually changing portion 211d is arranged in the shape of a truncated square pyramid. The vertex portion of the gradually changing portion 211d is located on the center line Lc.

The gradually changing portion 211d overlaps with the solar battery cell 113, as seen in the thickness direction of the solar battery cell 113. In the present embodiment, the gradually changing portion 211d overlaps with the end portion of the solar battery cell 113, as seen in the thickness direction of the solar battery cell 113. The terminal end of the gradually changing portion 211d that is located farthest away from the center line Lc overlaps with the terminal end of the solar battery cell 113, as seen in the thickness direction of the solar battery cell 113.

In the joint surface with the sealing material portion 214, the first cover 211 has a surrounding portion 211e surrounding the circumference of the gradually changing portion 211d. The surrounding portion 211e is formed of a horizontal surface and arranged in a lattice shape as seen in the thickness direction of the solar battery cell 113.

In the joint surface with the sealing material portion 214, the second cover 212 has a gradually changing portion 212d that is gradually decreased in thickness such that the sealing material portion 214 is gradually increased in thickness as being farther away from the center portion of the solar battery cell 113.

In the present embodiment, the gradually changing portion 212d is formed of an inclined surface that is inclined so as to be farther away from the solar battery cell 113 as being farther away from the center line Lc. The gradually changing portion 212d is arranged in a rectangular shape, as seen in the thickness direction of the solar battery cell 113. In other words, the gradually changing portion 212d is arranged in the shape of a truncated square pyramid. The vertex portion of the gradually changing portion 212d is located on the center line Lc.

The gradually changing portion 212d overlaps with the solar battery cell 113, as seen in the thickness direction of the solar battery cell 113. In the present embodiment, the gradually changing portion 212d overlaps with the end portion of the solar battery cell 113, as seen in the thickness direction of the solar battery cell 113. The terminal end of the gradually changing portion 212d that is located farthest away from the center line Lc overlaps with the terminal end of the solar battery cell 113, as seen in the thickness direction of the solar battery cell 113.

In the joint surface with the sealing material portion 214, the second cover 212 has a surrounding portion 212e surrounding the circumference of the gradually changing portion 212d. The surrounding portion 212e is formed of a horizontal surface and arranged in a lattice shape as seen in the thickness direction of the solar battery cell 113.

The minimum thickness of the sealing material portion 214 between the solar battery cell 113 and the first cover 211 is indicated by $t_1$. The minimum thickness of the sealing material portion 214 between the solar battery cell 113 and the second cover 212 is indicated by $t_2$. As the minimum thickness $t_1$ and the minimum thickness $t_2$ of the sealing material portion 214, the minimum thickness required to seal the solar battery cell 113 is ensured.

The thickness of the sealing material portion 214 between the first cover 211 and the terminal end of the solar battery cell 113 in the width direction is indicated by $t_3$. The thickness of the sealing material portion 214 between the second cover 212 and the terminal end of the solar battery cell 113 in the width direction is indicated by $t_4$. As the thickness $t_3$ and the thickness $t_4$ of the sealing material portion 214, the minimum thickness is ensured, which is required to prevent the sealing material portion 214 from peeling off from each of the first cover 211 and the second cover 212 due to the shearing strain $\gamma$ of the sealing material portion 214 described later.

Also in the solar battery module 210 according to the present embodiment, the sealing material portion 214 between the solar battery cell 113 and each of the gradually changing portions 211d and 212d is increased in thickness at an approximately constant rate as being farther away from the center of the solar battery cell 113 in the width direction. Therefore, the shearing strain $\gamma$ of the sealing material portion 214 between the solar battery cell 113 and each of the gradually changing portions 211d and 212d exhibits a constant value.

Each of the gradually changing portions 211d and 212d overlaps with the end portion of the solar battery cell 113 as seen in the thickness direction of the solar battery cell 113. Accordingly, the shearing strain $\gamma$ of the

sealing material portion 214 between the solar battery cell 113 and each of the gradually changing portions 211d and 212d is set at an approximately constant value, so that the sealing material portion 214 can be suppressed from peeling off from each of the first cover 211 and the second cover 212 at a position where it faces the end portion of the solar battery cell 113 in its width direction.

In the solar battery module 210 according to the present embodiment, in each of the first cover 211 and the second cover 212, the vertex portions of the gradually changing portions 211d and 212d are located on the center line Lc, and the thickness $t_1$ and the thickness $t_2$ of the sealing material portion 214 are the smallest on the center line Lc of the solar battery cell 113. Thereby, the jointing force between the solar battery cell 113 and the vertex portion of each of the gradually changing portions 211d and 212d is ensured, so that the positional displacement of the solar battery cell 113 in its width direction can be suppressed.

The solar battery module according to the third embodiment of the present invention will be hereinafter described. Since a solar battery module 310 according to the present embodiment is different from the solar battery module 210 according to the second embodiment only in that the gradually changing portion in each of the first cover and the second cover is formed of a curved surface, the description of other configurations will not be repeated.

(Third Embodiment)

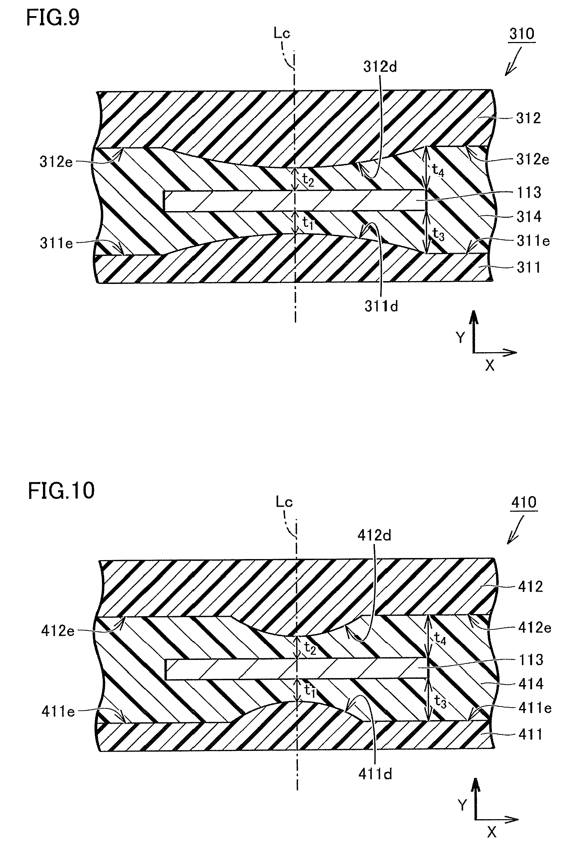

Fig. 9 is a cross-sectional view showing the configuration of a solar battery module according to the third embodiment of the present invention. Fig. 9 is a diagram shown in cross section as seen from the same direction as that in Fig. 3. Also in Fig. 9, the width direction and the thickness direction of the solar battery cell are indicated by X and Y, respectively. Fig. 9 also shows a center line Lc passing through the center of the solar battery cell in the width direction and extending in the thickness direction of the solar battery cell.

As shown in Fig. 9, the solar battery module 310 according to the third embodiment of the present invention includes: a first cover 311 formed in a plate shape; a second cover 312 formed in a plate shape and arranged so as to face the first cover 311; a solar battery cell 113 arranged between the first cover 311 and the second cover 312; and a sealing material portion 314 joining the first cover 311 and the second cover 312 while filling a space therebetween to seal the solar battery cell 113.

In the joint surface with the sealing material portion 314, the first cover 311 has a gradually changing portion 311d that is gradually decreased in thickness such that the sealing material portion 314 is gradually increased in thickness as being farther away from the center portion of the solar battery cell 113.

In the present embodiment, the gradually changing portion 311d is formed of a curved surface that is curved so as to be farther away from the solar battery cell 113 as being farther away from the center line Lc. The gradually changing portion 311d is arranged in a rectangular shape, as seen in the thickness direction of the solar battery cell 113. In other words, the gradually changing portion 311d is arranged in a dome shape. The vertex portion of the gradually changing portion 311d is located on the center line Lc.

The gradually changing portion 311d overlaps with the solar battery cell 113, as seen in the thickness direction of the solar battery cell 113. In the present embodiment, the gradually changing portion 311d overlaps with the end portion of the solar battery cell 113, as seen in the thickness direction of the solar battery cell 113. The terminal end of the gradually changing portion 311d that is located farthest away from the center line Lc overlaps with the terminal end of the solar battery cell 113, as seen in the thickness direction of the solar battery cell 113.

In the joint surface with the sealing material portion 314, the first cover 311 has a surrounding portion 311e surrounding the circumference of the gradually changing portion 311d. The surrounding portion 311e is formed of a horizontal surface and arranged in a lattice shape as seen in the thickness direction of the solar battery cell 113.

In the joint surface with the sealing material portion 314, the second cover 312 has a gradually changing portion 312d that is gradually decreased in thickness such that the sealing material portion 314 is gradually increased in thickness as being farther away from the center portion of the solar battery cell 113.

In the present embodiment, the gradually changing portion 312d is formed of a curved surface that is curved so as to be farther away from the solar battery cell 113 as being farther away from the center line Lc. The gradually changing portion 312d is arranged in a rectangular shape, as seen in the thickness direction of the solar battery cell 113. In other words, the gradually changing portion 312d is arranged in a dome shape. The vertex portion of the gradually changing portion 312d is located on the center line Lc.

The gradually changing portion 312d overlaps with the solar battery cell 113, as seen in the thickness direction of the solar battery cell 113. In the present embodiment, the gradually changing portion 312d overlaps with the end portion of the solar battery cell 113, as seen in the thickness direction of the solar battery cell 113. The terminal end of the gradually changing portion 312d that is located farthest away from the center line Lc overlaps with the terminal end of the solar battery cell 113, as seen in the thickness direction of the solar battery cell 113.

In the joint surface with the sealing material portion 314, the second cover 312 has a surrounding portion 312e surrounding the circumference of the gradually changing portion 312d. The surrounding portion 312e is formed of a horizontal surface and arranged in a lattice shape as seen in the thickness direction of the solar battery cell 113.

The minimum thickness of the sealing material portion 314 between the solar battery cell 113 and the first cover 311 is indicated by $t_1$. The minimum thickness of the sealing material portion 314 between the solar battery cell 113 and the second cover 312 is indicated by $t_2$. As the minimum thickness $t_1$ and the minimum thickness $t_2$ of the sealing material portion 314, the minimum thickness required to seal the solar battery cell 113 is ensured.

The thickness of the sealing material portion 314 between the first cover 311 and the terminal end of the solar battery cell 113 in its width direction is indicated by $t_3$. The thickness of the sealing material portion 314 between the second cover 312 and the terminal end of the solar battery cell 113 in its width direction is indicated by $t_4$. As the thickness $t_3$ and the thickness $t_4$ of the sealing material portion 314, the minimum thickness is ensured, which is required to prevent the sealing material portion 314 from peeling off from each of the first cover 311 and the second cover 312 due to the shearing strain $\gamma$ of the sealing material portion 314 described later.

In the solar battery module 310 according to the present embodiment, the sealing material portion 314 between the solar battery cell 113 and each of the gradually changing portions 311d and 312d is increased in thickness as being farther away from the center of the solar battery cell 113 in its width direction. Therefore, the shearing strain $\gamma$ of the sealing material portion 314 between the solar battery cell 113 and each of the gradually changing portions 311d and 312d exhibits an approximately constant value.

Each of the gradually changing portions 311d and 312d overlaps with the end portion of the solar battery cell 113, as seen in the thickness direction of the solar battery cell 113. Accordingly, the shearing strain $\gamma$ of the sealing material portion 314 between the solar battery cell 113 and each of the gradually changing portions 311d and 312d is set at an approximately constant value, so that the sealing material portion 314 can be suppressed from peeling off from each of the first cover 311 and the second cover 312 at the position where it faces the end portion of the solar battery cell 113 in its width direction.

In the solar battery module 310 according to the present embodiment, in each of the first cover 311 and the second cover 312, the vertex portion of each of the gradually changing portions 311d and 312d is located on the center line Lc, and the thickness $t_1$ and the thickness $t_2$ of the sealing material portion 314 are the smallest on the center line Lc of the solar battery cell 113. Thereby, the jointing force between the solar battery cell 113 and the vertex portion of each of the gradually changing portions 311d and 312d is ensured, so that the positional displacement of the solar battery cell 113 in its width direction can be suppressed.

The solar battery module according to the fourth embodiment of the present invention will be hereinafter described. A solar battery module 410 according to the present embodiment is different from the solar battery module 310 according to the third embodiment only in that the terminal end of the gradually changing portion in each of the first cover and the second cover is located on the inner side relative to the terminal end of the solar battery cell 113, as seen in the thickness direction of the solar battery cell 113. Accordingly, the description of other configurations will not be repeated.

(Fourth Embodiment)

Fig. 10 is a cross-sectional view showing the configuration of a solar battery module according to the fourth embodiment of the present invention. Fig. 10 is a diagram shown in cross section as seen from the same direction as that in Fig. 3. Also in Fig. 10, the width direction and the thickness direction of the solar battery cell are indicated by X and Y, respectively. Fig. 10 also shows a center line Lc passing through the center of the solar battery cell in the width direction and extending in the thickness direction of the solar battery cell.

As shown in Fig. 10, the solar battery module 410 according to the fourth embodiment of the present invention includes: a first cover 411 formed in a plate shape; a second cover 412 formed in a plate shape and arranged so as to face the first cover 411; a solar battery cell 113 arranged between the first cover 411 and the second cover 412; and a sealing material portion 414 joining the first cover 411 and the second cover 412 while filling a space therebetween to seal the solar battery cell 113.

In the joint surface with the sealing material portion 414, the first cover 411 has a gradually changing portion 411d that is gradually decreased in thickness such that the sealing material portion 414 is gradually increased in thickness as being farther away from the center portion of the solar battery cell 113.

In the present embodiment, the gradually changing portion 411d is formed of a curved surface that is curved so as to be farther away from the solar battery cell 113 as being farther away from the center line Lc. The gradually changing portion 411d is arranged in a rectangular shape as seen in the thickness direction of the solar battery cell 113. In other words, the gradually changing portion 411d is arranged in a dome shape. The vertex portion of the gradually changing portion 411d is located on the center line Lc.

The gradually changing portion 411d overlaps with the solar battery cell 113, as seen in the thickness direction of the solar battery cell 113. In the present embodiment, the gradually changing portion 411d dose not overlap with the end portion of the solar battery cell 113, as seen in the thickness direction of the solar battery cell 113. The terminal end of the gradually changing portion 411d that is located farthest away from the center line Lc is located on the inner side relative to the terminal end of the solar battery cell 113, as seen in the thickness direction of the solar battery cell 113.

In the joint surface with the sealing material portion 414, the first cover 411 has a surrounding portion 411 e surrounding the circumference of the gradually changing portion 411d. The surrounding portion 411e is formed of a horizontal surface and arranged in a lattice shape as seen in the thickness direction of the solar battery cell 113.

In the joint surface with the sealing material portion 414, the second cover 412 has a gradually changing portion 412d that is gradually decreased in thickness such that the sealing material portion 414 is gradually increased in thickness as being farther away from the center portion of the solar battery cell 113.

In the present embodiment, the gradually changing portion 412d is formed of a curved surface that is curved so as to be farther away from the solar battery cell 113 as being farther away from the center line Lc. The gradually changing portion 412d is arranged in a rectangular shape as seen in the thickness direction of the solar battery cell 113. In other words, the gradually changing portion 412d is arranged in a dome shape. The vertex portion of the gradually changing portion 412d is located on the center line Lc.

The gradually changing portion 412d overlaps with the solar battery cell 113, as seen in the thickness direction of the solar battery cell 113. In the present embodiment, the gradually changing portion 412d does not overlap with the end portion of the solar battery cell 113, as seen in the thickness direction of the solar battery cell 113. The terminal end of the gradually changing portion 412d that is located farthest away from the center line Lc is located on the inner side relative to the terminal end of the solar battery cell 113, as seen in the thickness direction of the solar battery cell 113.

In the joint surface with the sealing material portion 414, the second cover 412 has a surrounding portion 412e surrounding the circumference of the gradually changing portion 412d. The surrounding portion 412e is formed of a horizontal surface and arranged in a lattice shape as seen in the thickness direction of the solar battery cell 113.

The minimum thickness of the sealing material portion 414 between the solar battery cell 113 and the first cover 411 is indicated by $t_1$. The minimum thickness of the sealing material portion 414 between the solar battery cell 113 and the second cover 412 is indicated by $t_2$. As the minimum thickness $t_1$ and the minimum thickness $t_2$ of the sealing material portion 414, the minimum thickness required to seal the solar battery cell 113 is ensured.

The thickness of the sealing material portion 414 between the first cover 411 and the terminal end of the solar battery cell 113 in the width direction is indicated by $t_3$. The thickness of the sealing material portion 414 between the second cover 412 and the terminal end of the solar battery cell 113 in the width direction is indicated by $t_4$. As the thickness $t_3$ and the thickness $t_4$ of the sealing material portion 414, the minimum thickness is ensured, which is required to prevent the sealing material portion 414 from peeling off from each of the first cover 411 and the second cover 412 due to the shearing strain $\gamma$ of the sealing material portion 414 described later.

In the solar battery module 410 according to the present embodiment, the sealing material portion 414 between the solar battery cell 113 and each of the gradually changing portions 411d and 412d is increased in thickness as being farther away from the center of the solar battery cell 113 in the width direction. Therefore, the shearing strain $\gamma$ of the sealing material portion 414 between the solar battery cell 113 and each of the gradually changing portions 411 d and 412d exhibits an approximately constant value.

Each of the gradually changing portions 411 d and 412d overlaps with the solar battery cell 113 as seen in the thickness direction of the solar battery cell 113. Accordingly, the shearing strain $\gamma$ of the sealing material portion 414 between the solar battery cell 113 and each of the gradually changing portions 411d and 412d is set at an approximately constant value, so that the shearing strain $\gamma$ of the sealing material portion 414 between the end portion of the solar battery cell 113 and each of the surrounding portions 411 e and 412e can be reduced. Consequently, the sealing material portion 414 can be suppressed from peeling off from each of the first cover 411 and the second cover 412 at the position where it faces the end portion of the solar battery cell 113 in its width direction.

In the solar battery module 410 according to the present embodiment, in each of the first cover 411 and the second cover 412, the vertex portions of the gradually changing portions 411d and 412d are located on the center line Lc, and the thickness $t_1$ and the thickness $t_2$ of the sealing material portion 414 are the smallest on the center line Lc of the solar battery cell 113. Thereby, the jointing force between the solar battery cell 113 and the vertex portion of each of the gradually changing portions 411 d and 412d is ensured, so that the positional displacement of the solar battery cell 113 in its width direction can be suppressed.

The solar battery module according to the fifth embodiment of the present invention will be hereinafter described. A solar battery module 510 according to the present embodiment is different from the solar battery module 310 according to the third embodiment only in that the terminal end of the gradually changing portion in each of the first cover and the second cover is located on the outside relative to the terminal end of the solar battery cell 113, as seen in the thickness direction of the solar battery cell 113. Accordingly, the description of other configurations will not be repeated.

(Fifth Embodiment)

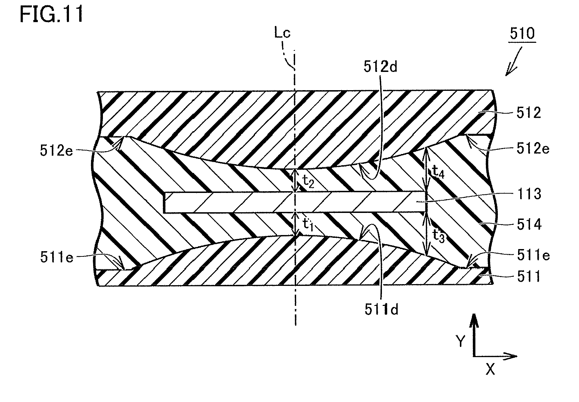

Fig. 11 is a cross-sectional view showing the configuration of a solar battery module according to the fifth embodiment of the present invention. Fig. 11 is a diagram shown in cross section as seen from the same direction as that in Fig. 3. Also in Fig. 11, the width direction and the thickness direction of the solar battery cell are indicated by X and Y, respectively. Fig. 11 also shows a center line Lc passing through the center of the solar battery cell in the width direction and extending in the thickness direction of the solar battery cell.

As shown in Fig. 11, the solar battery module 510 according to the fifth embodiment of the present invention includes: a first cover 511 formed in a plate shape; a second cover 512 formed in a plate shape and arranged so as to face the first cover 511; a solar battery cell 113 arranged between the first cover 511 and the second cover 512; and a sealing material portion 514 joining the first cover 511 and the second cover 512 while filling a space therebetween to seal the solar battery cell 113.

In the joint surface with the sealing material portion 514, the first cover 511 has a gradually changing portion 511 d that is gradually decreased in thickness such that the sealing material portion 514 is gradually increased in thickness as being farther away from the center portion of the solar battery cell 113.

In the present embodiment, the gradually changing portion 511 d is formed of a curved surface that is curved so as to be farther away from the solar battery cell 113 as being farther away from the center line Lc. The gradually changing portion 511 d is arranged in a rectangular shape, as seen in the thickness direction of the solar battery cell 113. In other words, the gradually changing portion 511d is arranged in a dome shape. The vertex portion of the gradually changing portion 511 d is located on the center line Lc.

The gradually changing portion 511 d overlaps with the solar battery cell 113 as seen in the thickness direction of the solar battery cell 113. In the present embodiment, the gradually changing portion 511d overlaps with the end portion of the solar battery cell 113, as seen in the thickness direction of the solar battery cell 113. The terminal end of the gradually changing portion 511d that is located farthest away from the center line Lc is located on the outside relative to the terminal end of the solar battery cell 113, as seen in the thickness direction of the solar battery cell 113.

In the joint surface with the sealing material portion 514, the first cover 511 has a surrounding portion 511 e surrounding the circumference of the gradually changing portion 511d. The surrounding portion 511 e is formed of a horizontal surface and arranged in a lattice shape as seen in the thickness direction of the solar battery cell 113.

In the joint surface with the sealing material portion 514, the second cover 512 has a gradually changing portion 512d that is gradually decreased in thickness such that the sealing material portion 514 is gradually increased in thickness as being farther away from the center portion of the solar battery cell 113.

In the present embodiment, the gradually changing portion 512d is formed of a curved surface that is curved so as to be farther away from the solar battery cell 113 as being farther away from the center line Lc. The gradually changing portion 512d is arranged in a rectangular shape, as seen in the thickness direction of the solar battery cell 113. In other words, the gradually changing portion 512d is arranged in a dome shape. The vertex portion of the gradually changing portion 512d is located on the center line Lc.

The gradually changing portion 512d overlaps with the solar battery cell 113, as seen in the thickness direction of the solar battery cell 113. In the present embodiment, the gradually changing portion 512d overlaps with the end portion of the solar battery cell 113, as seen in the thickness direction of the solar battery cell 113. The terminal end of the gradually changing portion 512d that is located farthest away from the center line Lc is located on the outside relative to the terminal end of the solar battery cell 113, as seen in the thickness direction of the solar battery cell 113.

In the joint surface with the sealing material portion 514, the second cover 512 has a surrounding portion 512e surrounding the circumference of the gradually changing portion 512d. The surrounding portion 512e is formed of a horizontal surface and arranged in a lattice shape as seen in the thickness direction of the solar battery cell 113.

The minimum thickness of the sealing material portion 514 between the solar battery cell 113 and the first cover 511 is indicated by $t_1$. The minimum thickness of the sealing material portion 514 between the solar battery cell 113 and the second cover 512 is indicated by $t_2$. As the minimum thickness $t_1$ and the minimum thickness $t_2$ of the sealing material portion 514, the minimum thickness required to seal the solar battery cell 113 is ensured.

The thickness of the sealing material portion 514 between the first cover 511 and the terminal end of the solar battery cell 113 in its width direction is indicated by $t_3$. The thickness of the sealing material portion 514 between the second cover 512 and the terminal end of the solar battery cell 113 in its width direction is indicated by $t_4$. As the thickness $t_3$ and the thickness $t_4$ of the sealing material portion 514, the minimum thickness is ensured, which is required to prevent the sealing material portion 514 from peeling off from each of the first cover 511 and the second cover 512 due to the shearing strain $\gamma$ of the sealing material portion 514 described later.

In the solar battery module 510 according to the present embodiment, the sealing material portion 514 between the solar battery cell 113 and each of the gradually changing portions 511d and 512d is increased in thickness as being farther away from the center of the solar battery cell 113 in the width direction. Therefore, the shearing strain $\gamma$ of the sealing material portion 514 between the solar battery cell 113 and each of the gradually changing portions 511d and 512d exhibits an approximately constant value.

Each of the gradually changing portions 511d and 512d overlaps with the end portion of the solar battery cell 113, as seen in the thickness direction of the solar battery cell 113. Accordingly, the shearing strain $\gamma$ of the sealing material portion 514 between the solar battery cell 113 and each of the gradually changing portions 511d and 512d is set at an approximately constant value, so that the sealing material portion 514 can be suppressed from peeling off from each of the first cover 511 and the second cover 512 at the position where it faces the end portion of the solar battery cell 113 in the width direction.

In the solar battery module 510 according to the present embodiment, in each of the first cover 511 and the second cover 512, the vertex portions of the gradually changing portions 511d and 512d are located on the center line Lc, and the thickness $t_1$ and the thickness $t_2$ of the sealing material portion 514 are the smallest on the center line Lc of the solar battery cell 113. Thereby, the jointing force between the solar battery cell 113 and the vertex portion of each of the gradually changing portions 511d and 512d is ensured, so that the positional displacement of the solar battery cell 113 in its width direction can be suppressed.

Although the embodiments of the present invention have been described as above, it should be understood that the embodiments disclosed herein are illustrative and non-restrictive in every respect. The scope of the present invention is defined by the terms of the claims, and is intended to include any modifications within the meaning and scope equivalent to the terms of the claims.

A solar battery module includes: a first cover (111) formed in a plate shape; a second cover (112) formed in a plate shape and arranged so as to face the first cover (111); a solar battery cell (113) arranged between the first cover (111) and the second cover (112); and a sealing material portion (114) joining the first cover (111) and the second cover (112) while filling a space therebetween to seal the solar battery cell (113). In a joint surface with the sealing material portion (114), at least one of the first cover (111) and the second cover (112) has a gradually changing portion (111d, 112d) that is gradually decreased in thickness such that the sealing material portion (114) is gradually increased in thickness as being farther away from a center portion of the solar battery cell (113). At least a part of the gradually changing portion (111d, 112d) overlaps with the solar battery cell (113), as seen in a thickness direction of the solar battery cell (113).

## Claims

1. A solar battery module comprising:

a first cover (111, 211, 311, 411, 511) formed in a plate shape;
a second cover (112, 212, 312, 412, 512) formed in a plate shape and arranged so as to face the first cover (111, 211, 311, 411, 511);
a solar battery cell (113) arranged between the first cover (111, 211, 311, 411, 511) and the second cover (112, 212, 312, 412, 512); and
a sealing material portion (114, 214, 314, 414, 514) joining the first cover (111, 211, 311, 411, 511) and the second cover (112, 212, 312, 412, 512) while filling a space therebetween to seal the solar battery cell (113),
in a joint surface with the sealing material portion (114, 214, 314, 414, 514), at least one of the first cover (111, 211, 311, 411, 511) and the second cover (112, 212, 312, 412, 512) having a gradually changing portion (111 d, 112d, 211 d, 212d, 311 d, 312d, 411 d, 412d, 511 d, 512d) that is gradually decreased in thickness such that the sealing material portion (114, 214, 314, 414, 514) is increased in thickness as being farther away from a center portion of the solar battery cell (113), and
at least a part of the gradually changing portion (111d, 112d, 211d, 212d, 311d, 312d, 411d, 412d, 511d, 512d) overlapping with the solar battery cell (113) as seen in a thickness direction of the solar battery cell (113).

2. The solar battery module according to claim 1, wherein the gradually changing portion (111d, 112d, 211d, 212d, 311d, 312d, 511 d, 512d) overlaps with an end portion of the solar battery cell (113) as seen in the thickness direction of the solar battery cell (113).

3. The solar battery module according to claim 1 or 2, wherein, in the joint surface with the sealing material portion (114), at least one of the first cover (111) and the second cover (112) has a horizontal portion (111f, 112f) that is located adjacent to the gradually changing portion (111d, 112d) so as to face the center portion of the solar battery cell (113).

4. The solar battery module according to any one of claims 1 to 3, wherein each of the first cover (111, 211, 311, 411, 511) and the second cover (112, 212, 312, 412, 512) has the gradually changing portion (111d, 112d, 211 d, 212d, 311 d, 312d, 411d, 412d, 511d, 512d).

5. The solar battery module according to any one of claims 1 to 3, wherein at least one of the first cover (111, 211, 311, 411, 511) and the second cover (112, 212, 312, 412, 512) that is higher in rigidity has the gradually changing portion (111d, 112d, 211d, 212d, 311d, 312d, 411d, 412d, 511d, 512d).

FIG.1

FIG.2

FIG.3

FIG.4

## FIG.5

## FIG.6

FIG.7

FIG.8

FIG.9

FIG.10

# FIG.11

Europäisches
Patentamt

European
Patent Office

Office européen
des brevets

# EUROPEAN SEARCH REPORT

Application Number

EP 16 16 1535

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 328 185 A1 (TOYOTA MOTOR CO LTD [JP]) 1 June 2011 (2011-06-01) * paragraphs [0016] - [0025], [0085]; claim 1; figures 1-3,8,9 * | 1,2,5 | INV. H01L31/048 |
| X | EP 1 732 141 A1 (GEN ELECTRIC [US]) 13 December 2006 (2006-12-13) * paragraphs [0010], [0011], [0017], [0023]; claims 1-6; figures 1, 5, 10 * | 1,3,5 | |
| X | JP 2011 124510 A (TOYOTA MOTOR CORP) 23 June 2011 (2011-06-23) * paragraphs [0015] - [0019], [0024] - [0026], [0056] - [0058], [0084] - [0093]; claim 1; figures 1,2,3,6,8,9 * | 1,2,5 | |
| X | JP 2011 103426 A (TOYOTA MOTOR CORP) 26 May 2011 (2011-05-26) * abstract; figures 1-4,7, 8, 10-12,16,17,19-21 * | 1,2,5 | |
| X | JP 2012 253183 A (TOYOTA MOTOR CORP; LINTEC CORP) 20 December 2012 (2012-12-20) * paragraphs [0016] - [0018], [0024], [0025], [0038] - [0043]; claim 1; figures 1,7,8 * | 1,2,5 | TECHNICAL FIELDS SEARCHED (IPC) H01L |
| A | JP 2001 119054 A (HITACHI LTD) 27 April 2001 (2001-04-27) * abstract; figures 1-4 * | 1,2,5 | |

The present search report has been drawn up for all claims

| Place of search | Date of completion of the search | Examiner |
|---|---|---|
| Berlin | 2 August 2016 | Visentin, Alberto |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.............................................................................
& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 16 16 1535

This annex lists the patent family members relating to the patent documents cited in the above-mentioned European search report.
The members are as contained in the European Patent Office EDP file on
The European Patent Office is in no way liable for these particulars which are merely given for the purpose of information.

02-08-2016

| Patent document cited in search report | | | Publication date | Patent family member(s) | | | Publication date |
|---|---|---|---|---|---|---|---|
| EP 2328185 | A1 | | 01-06-2011 | CN<br>EP<br>JP<br>US<br>WO | 102138222<br>2328185<br>5381717<br>2012168076<br>2011036802 | A<br>A1<br>B2<br>A1<br>A1 | 27-07-2011<br>01-06-2011<br>08-01-2014<br>05-07-2012<br>31-03-2011 |
| EP 1732141 | A1 | | 13-12-2006 | CN<br>EP<br>JP<br>US | 1877865<br>1732141<br>2006344964<br>2006272698 | A<br>A1<br>A<br>A1 | 13-12-2006<br>13-12-2006<br>21-12-2006<br>07-12-2006 |
| JP 2011124510 | A | | 23-06-2011 | NONE | | | |
| JP 2011103426 | A | | 26-05-2011 | JP<br>JP | 5428782<br>2011103426 | B2<br>A | 26-02-2014<br>26-05-2011 |
| JP 2012253183 | A | | 20-12-2012 | NONE | | | |
| JP 2001119054 | A | | 27-04-2001 | NONE | | | |

EPO FORM P0459

For more details about this annex : see Official Journal of the European Patent Office, No. 12/82

**EP 3 073 536 A1**

## REFERENCES CITED IN THE DESCRIPTION

### Patent documents cited in the description

- JP 2015062510 A

- JP 2005191479 A